# EUROPÄISCHE PATENTANMELDUNG

(11) **EP 3 933 912 A1**
(43) Veröffentlichungstag der Anmeldung: **05.01.2022**
(21) Anmeldenummer: 20183240.9
(22) Anmeldetag: 30.06.2020
(51) Int. Cl.: H01L 23/367, H05K 7/20

(54) **KÜHLKÖRPER FÜR EIN ELEKTRONISCHES LEISTUNGSBAUTEIL**

(71) Anmelder: Andreas Stihl AG & Co. KG, 71336 Waiblingen (DE)
(72) Erfinder: WICHERT, Rene, D-73568 Duriangen (DE); FIESELER, Martin, D-45134 Essen (DE)
(74) Vertreter: Wasmuth, Rolf

(57) **Zusammenfassung**

1. Die Erfindung betrifft eine Vorrichtung zur Abfuhr von Wärme eines auf einer Platine (1) montierten elektronischen Bauelementes (3) mit einem Kühlkörper, insbesondere zur Abfuhr von Wärme eines elektronischen Leistungsbauteils (7 bis 14). Zur Abfuhr von Bottomwärme des elektronischen Bauelementes (3) ist auf der Platine (1) zumindest ein Wärme abführender Wärmeleitabschnitt (20, 21, 22, 23) ausgebildet, wobei der Kühlkörper (5,6) in Wärme übertragender Verbindung mit dem Wärmeleitabschnitt (20, 21, 22, 23) der Platine (1) steht. Nach der Erfindung ist vorgesehen, dass der Kühlkörper (5, 6) mit einem Fußabschnitt (34, 35) unmittelbar auf dem Wärmeleitabschnitt (20, 21, 22, 23) der Platine (1) aufsteht. Im Grundkörper (25) des Kühlkörpers (5, 6) ist eine Ausnehmung (30) ausgebildet, wobei das elektronische Bauelement (3) zumindest teilweise in der Ausnehmung (30) liegt.

## Beschreibung

Die Erfindung betrifft eine Vorrichtung mit einem Kühlkörper zur Abfuhr von Wärme eines auf einer Platine montierten elektronischen Bauelementes wie eines elektronischen Leistungsbauteils, zum Beispiel eines Leistungstransistors, eines MOSFET eines Shunt-Widerstandes oder dergleichen.

Die Anforderungen an elektronische Bauelemente zum Steuern und/oder Schalten von elektrischen Lasten sind sehr hoch. Die in der Technik fortschreitende Miniaturisierung führt zu konstruktiv kleinen Bauelementen, die immer größere Ströme steuern müssen. Dies führt im elektronischen Bauelement zu einer technisch nicht zu vermeidenden Abwärme, die über entsprechende Kühlkörper abzuführen ist. Die Kühlkörper stehen dabei mittelbar oder unmittelbar in Wärme übertragender Verbindung mit dem elektronischen Bauelement selbst und vergrößern die Wärme abgebende Fläche.

Sind auf einer Platine mehrere Bauelemente eng beieinander angeordnet, kann die Abwärme zu einer unzulässigen Betriebstemperatur der Bauelemente führen und eine Übertemperatur deren Ausfall verursachen. Daher kann in einer Platine für elektronische Baugruppen auch zumindest ein Wärmeleitpfad vorgesehen sein, um insbesondere die Bottomwärme und zweckmäßig auch die Topwärme des Bauelementes abzuführen. Zwischen dem auf dem elektronischen Bauelement meist aufliegenden Kühlkörper und dem Wärmeleitpfad muss eine Wärme übertragende Verbindung geschaffen werden, z. B. durch Wärme übertragende Zwischenstücke. Die angeordneten Zwischenstücke stören einen effektiven Wärmefluss.

Der Erfindung liegt die Aufgabe zugrunde, einen Kühlkörper zur Abfuhr von Wärme eines auf einer Platine montierten elektronischen Bauelementes anzugeben, mit dem effektiv insbesondere die Bottomwärme des elektronischen Bauelementes abgeführt werden kann.

Die Aufgabe wird dadurch gelöst, dass der Kühlkörper mit einem Fußabschnitt unmittelbar auf einem die Bottomwärme abführenden Wärmeleitabschnitt der Platine aufsteht, so dass die Bottomwärme über den Wärmeleitabschnitt der Platine und den Kühlkörper zügig abgeführt wird. Der Kühlkörper ist ferner im Fußabschnitt mit einer Ausnehmung ausgebildet, in der zumindest teilweise das elektronische Bauelement aufgenommen ist. Dadurch wird erreicht, dass der Fußabschnitt ohne Verwendung von Zwischenstücken unmittelbar auf dem Wärmeleitabschnitt der Platine aufsteht, wodurch ein guter Wärmeübergang erzielt ist.

Vorteilhaft sind am Grundkörper des Kühlkörpers zwei Fußabschnitte ausgebildet. Dabei ist zweckmäßig vorgesehen, dass auf einander gegenüberliegenden Seiten der Ausnehmung je ein Fußabschnitt ausgebildet ist.

In vorteilhafter Weiterbildung der Erfindung weist die Platine auf gegenüberliegenden Seiten des elektronischen Bauelementes jeweils zumindest einen Wärmeleitabschnitt auf, wobei der Kühlkörper das elektronische Bauelement übergreift und auf den Wärmeleitabschnitten der Platine aufsteht. Der Kühlkörper hat somit auf beiden Seiten des elektronischen Bauelementes eine Wärme übertragende Verbindung mit den Wärmeleitabschnitten der Platine, wodurch eine gute Abfuhr der Bottomwärme gewährleistet ist. Insbesondere steht der Kühlkörper unmittelbar auf beiden Wärmeleitabschnitten auf. Mit dem Begriff "unmittelbar" ist zum Ausdruck gebracht, dass zwischen dem Kühlkörper und den Wärmeleitabschnitten keine weiteren konstruktiven Elemente angeordnet sind. Zwischen dem Kühlkörper und den Wärmeleitabschnitten der Platine kann bei Bedarf ein wärmeleitendes Material in Form eines Pads oder einer Wärmeleitpaste oder eines Wärmeleitklebers vorgesehen sein. Insbesondere überspannt der Kühlkörper das elektronische Bauelement nach Art einer Brücke.

In Weiterbildung der Erfindung ist vorgesehen, dass mehrere elektronische Bauelemente, insbesondere Leistungsbauteile, längs zumindest eines Wärmeleitabschnitts der Platine in einer Reihe nebeneinander angeordnet sind. Den in einer Reihe angeordneten elektronischen Bauelementen wie Leistungsbauteilen ist zusammen mit den zugeordneten Wärmeleitabschnitten der Platine ein gemeinsamer Kühlkörper zugeordnet. Der Kühlkörper ist dabei zweckmäßig derart ausgebildet, dass die elektronischen Bauelemente bzw. Leistungsbauteile der Reihe in einer insbesondere gemeinsamen Ausnehmung des Kühlkörpers liegen und der Kühlkörper mit zumindest einem Fußabschnitt auf einem Wärmeleitabschnitt neben den elektronischen Bauelementen bzw. Leistungsbauteilen auf der Platine aufsteht.

Der Kühlkörper weist insbesondere beidseitig der Ausnehmung jeweils einen Fußabschnitt auf, der sich zumindest über die Länge eines elektronischen Bauelementes oder einer Reihe von elektronischen Bauelementen bzw. Leistungsbauteilen erstreckt.

Sind mehrere elektronische Bauelemente bzw. Leistungsbauteile in einer Reihe vorgesehen, weist der Kühlkörper insbesondere nach Art eines Steges beidseitig der Ausnehmung verlaufende Fußabschnitte auf, die sich über die Länge der Reihe der elektronischen Bauelemente erstrecken. Jeder Fußabschnitt steht auf beiden Längsseiten der Reihe jeweils auf einem Wärmeleitabschnitt der Platine vorzugsweise unmittelbar auf.

In besonderer Weiterbildung der Erfindung ist vorgesehen, dass in die Ausnehmung des Kühlkörpers zumindest ein auf der Platine festgelegtes Zentrierelement eingreift, das geeignet und bestimmt ist, den Kühlkörper relativ zum elektronischen Bauelement auszurichten. Insbesondere ist vorgesehen, in Reihe mit zumindest einem elektronischen Bauelement zumindest ein Zentrierelement anzuordnen. Das auf der Platine festgelegte Zentrierelement greift in die Ausnehmung ein und richtet durch seine Lage in der Ausnehmung den Kühlkörper relativ zum elektronischen Bauelement aus. Die Ausnehmung ist insbesondere größer als das Bauelement ausgebildet. Das Bauelement liegt mit seitlichem Abstand in der Ausnehmung. Durch die Ausrichtung des Kühlkörpers relativ zum elektronischen Bauelement ist gewährleistet, dass der insbesondere elektrisch leitende Kühlkörper nicht mit den oft zahlreich vorhandenen Anschlüssen des elektronischen Bauelements in Kontakt kommt, so dass elektrische Kurzschlüsse sicher vermieden sind. Darüber hinaus gewährleistet das Zentrierelement eine genaue Positionierung des Kühlkörpers auf dem Wärmeleitabschnitt, so dass ein guter Wärmeübergang gewährleistet und damit eine gute Wärmeabfuhr gesichert ist. Das Ansteigen der Betriebstemperatur des elektronischen Bauelementes über eine zulässige Temperatur kann sicher verhindert werden.

Für eine präzise Ausrichtung der Lage des Zentrierelementes in der Aufnahme und damit der Lage des Kühlkörpers auf der Platine ist vorgesehen, dass quer zum Wärmeleitabschnitt die Länge eines Zentrierelementes der Breite der Ausnehmung im Kühlkörper derart entspricht, dass ein in die Ausnehmung eingreifendes Zentrierelement geeignet ist, den Kühlkörper quer zur Längsrichtung des Wärmeleitabschnittes und des elektronischen Bauelementes auszurichten.

Das Zentrierelement weist vorteilhaft eine Höhe auf, die geringer als oder gleich der Tiefe der Ausnehmung im Kühlkörper ist, insbesondere der Höhe des Bauelementes über der Oberfläche der Platine ist. Wird in einer Weiterbildung der Erfindung die Tiefe der Ausnehmung im Kühlkörper ferner an die Bauhöhe des elektronischen Bauelementes über der Oberfläche der Platine angepasst, kann ein in der Ausnehmung liegendes elektronisches Bauelement bzw. Leistungsbauteil vorteilhaft in Kontakt mit dem Boden der Ausnehmung kommen, wodurch die Topwärme des elektronischen Bauelementes bzw. des Leistungsbauteils sicher abgeführt werden kann.

Das Zentrierelement kann in seiner Grundform als Rechteck ausgebildet sein, wobei die Länge des Zentrierelementes einerseits zweckmäßig an die Breite der Ausnehmung im Kühlkörper angepasst ist und vorteilhaft andererseits den Abstand zwischen den Wärmeleitabschnitten einer Reihe überbrückt. Das Zentrierelement kann aus einem wärmeleitenden Material bestehen. Vorteilhaft besteht das Zentrierelement aus einem elektrisch nicht leitenden Material.

Um Toleranzen bei der mechanischen Montage der Zentrierelemente auf der Platine auszugleichen, ist vorgesehen, die Ecken des Zentrierelementes zu runden. Dadurch kann gewährleistet werden, dass bei der Montage auftretende leichte Winkelfehlstellungen des Zentrierelementes nicht zu Montageproblemen beim Aufsetzen der Kühlkörper auf die Reihe der elektronischen Bauelemente bzw. eines einzelnen Leistungsbauteils führen.

In Weiterbildung der Erfindung werden die Stirnseiten des rechteckförmigen Zentrierelementes gerundet ausgeführt. Bevorzugt bilden die gerundeten Stirnseiten Kreissegmente, wobei die Stirnseiten mit einem Radius zu einem Kreismittelpunkt liegen.

Zur Ausrichtung des Kühlkörpers relativ zu einer Reihe von elektronischen Bauelementen bzw. Leistungsbauteilen ist vorgesehen, dass zumindest ein Zentrierelement in Reihe mit zumindest einem elektronischen Bauelement angeordnet ist. Die Länge des Zentrierelementes quer zum Wärmeleitabschnitt entspricht derart der Breite der Ausnehmung im Grundkörper des Kühlkörpers, dass ein in die Ausnehmung eingreifendes Zentrierelement geeignet ist, den Kühlkörper quer zur Längsrichtung der Reihe der elektronischen Bauelemente bzw. Leistungsbauteile auszurichten. Ein elektrischer Kontakt des Kühlkörpers mit den Anschlussfähnchen der elektronischen Bauteile bzw. der Leistungsbauteile kann so sicher vermieden werden.

Bevorzugt ist vorgesehen, im Anfangsabschnitt und im Endabschnitt einer Reihe der elektronischen Bauelemente zumindest ein Zentrierelement anzuordnen.

Zweckmäßig bildet ein Zentrierelement einen Anfang einer Reihe und ein Zentrierelement ein Ende einer Reihe der elektronischen Bauelemente bzw. der Leistungsbauteile. Durch die Anordnung des Zentrierelementes im Endabschnitt und im Anfangsabschnitt einer Reihe ist eine präzise Ausrichtung des Kühlkörpers relativ zur Reihe gewährleistet.

Insbesondere ist vorgesehen, dass das elektronische Bauelement in Wärme übertragender Verbindung in der Ausnehmung liegt, so dass auch die Topwärme des elektronischen Bauelementes abgeführt werden kann. Die Ausbildung des Kühlkörpers zur gleichzeitigen Wärmekontaktierung des Wärmeleitabschnitts der Platine und des elektronischen Bauelementes führt zu einer kompakten Bauweise, die eine hohe Effizienz zur Abfuhr der Betriebswärme des elektronischen Bauelementes aufweist.

Das elektronische Bauelement weist eine der Platine zugewandte Unterseite und eine von der Platine abgewandte Oberseite auf. Die Unterseite des elektronischen Bauelementes steht zur Abfuhr von Bottomwärme mit dem Wärmeleitabschnitt der Platine in Wärme übertragender Verbindung. Die Oberseite des elektronischen Bauelementes kann zur Abfuhr von Topwärme vorteilhaft mit dem Boden der Ausnehmung des Kühlkörpers in Wärme übertragender Verbindung stehen. Dabei ist die Ausbildung so getroffen, dass die Oberseite des Bauelementes und die Wärmeleitabschnitte in der Platine unmittelbar in einem Wärme übertragenden Kontakt mit dem Kühlkörper stehen. Der Boden der Ausnehmung des Kühlkörpers kann unmittelbar auf der Oberseite des Bauelementes aufliegen, wobei zwischen der Oberseite des Bauelementes und dem Boden der Ausnehmung ein wärmeleitendes Material in Form eines Pads, einer Wärmeleitpaste, eines Wärmeleitklebers, eines Gases (z. B. Luft) oder eines Vakuums vorgesehen sein kann. Der Wärmeübergang vom Bauelement auf den Kühlkörper kann direkt über eine Wärmeleitung oder indirekt über Konvektion oder Strahlung erfolgen.

Weitere Merkmale der Erfindung ergeben sich aus den weiteren Ansprüchen, der Beschreibung und der Zeichnung, in der ein Ausführungsbeispiel der Erfindung im Einzelnen beschrieben ist. Die in den Ansprüchen und/oder der Beschreibung genannten Merkmale können im Sinne der Erfindung beliebig miteinander kombiniert werden, um eine verbesserte Wärmeabfuhr eines elektronischen Bauelementes zu erzielen.

Es zeigen:
- Fig. 1: in schematischer Darstellung eine Vorrichtung zur Abfuhr von Wärme von auf einer Platine angeordneten elektronischen Bauelementen wie Leistungsbauteilen mit einem Kühlkörper,
- Fig. 2: in schematischer Darstellung eine Platine nach Figur 1 mit elektronischen Bauelementen wie Leistungsbauteilen ohne Kühlkörper,
- Fig. 3: eine Ansicht eines Ausführungsbeispiels eines ersten Kühlkörpers für ein elektronisches Bauelement wie ein Leistungsbauteil,
- Fig. 4: eine Ansicht des ersten Kühlkörpers von unten mit einer in Längsrichtung des Kühlkörpers verlaufenden Aufnahmenut,
- Fig. 5: eine Ansicht eines Ausführungsbeispiels eines zweiten Kühlkörpers für elektronische Bauelemente wie Leistungsbauteile,
- Fig. 6: eine Ansicht des zweiten Kühlkörpers von unten mit einer in Längsrichtung des Kühlkörpers verlaufenden Aufnahmenut,
- Fig. 7: in schematischer Darstellung einen Schnitt durch die Vorrichtung zur Abfuhr von Wärme von auf einer Platine angeordneten elektronischen Bauelementen wie Leistungsbauteilen und angeordneten Kühlkörpern nach Fig. 1,
- Fig. 8: in schematischer Darstellung einen Längsschnitt durch die Platine nach Fig. 1 auf Höhe des ersten Kühlkörpers,
- Fig. 9: in schematischer Darstellung eine Ansicht von unten auf eine in einem Kühlkörper als Längsnut ausgebildete Ausnehmung mit in die Ausnehmung eingreifenden Zentrierelementen,
- Fig. 10: eine Draufsicht auf ein rechteckiges Zentrierelement mit gerundeten Ecken,
- Fig. 11: eine Draufsicht auf ein rechteckiges Zentrierelement mit gerundeten Stirnseiten,
- Fig. 12: eine Seitenansicht eines Zentrierelementes nach den Figuren 10 und 11.

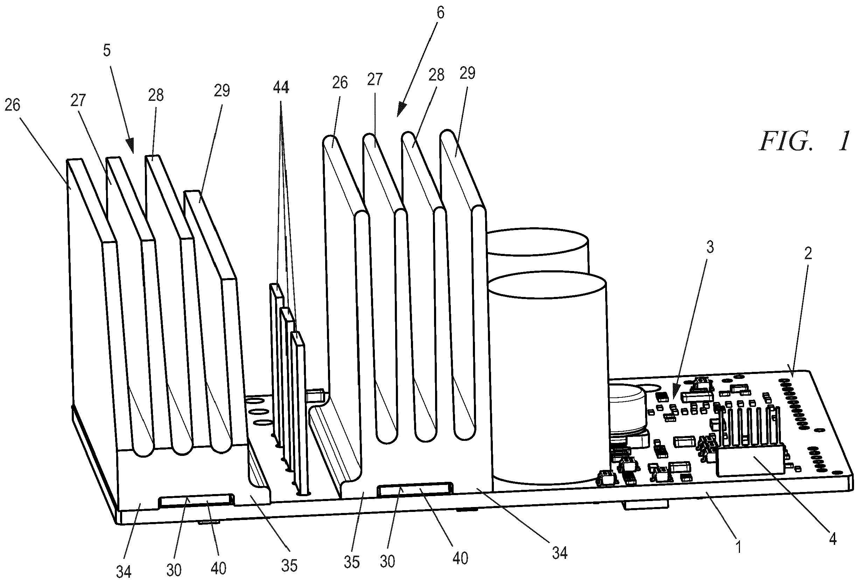

Die in Fig. 1 gezeigte Platine 1 trägt insbesondere auf ihrer Platinenoberseite 2 eine Vielzahl von elektronischen Bauelementen 3, von denen einige elektronische Bauelemente 3 als Leistungsbauteile 7 bis 14 ausgebildet sind, sowie Steckanschlüsse 4 zur Verbindung mit weiteren elektronischen Baugruppen und/oder Kontaktzungen 44 zur Stromversorgung einer Last wie einem EC-Motor oder dergleichen.

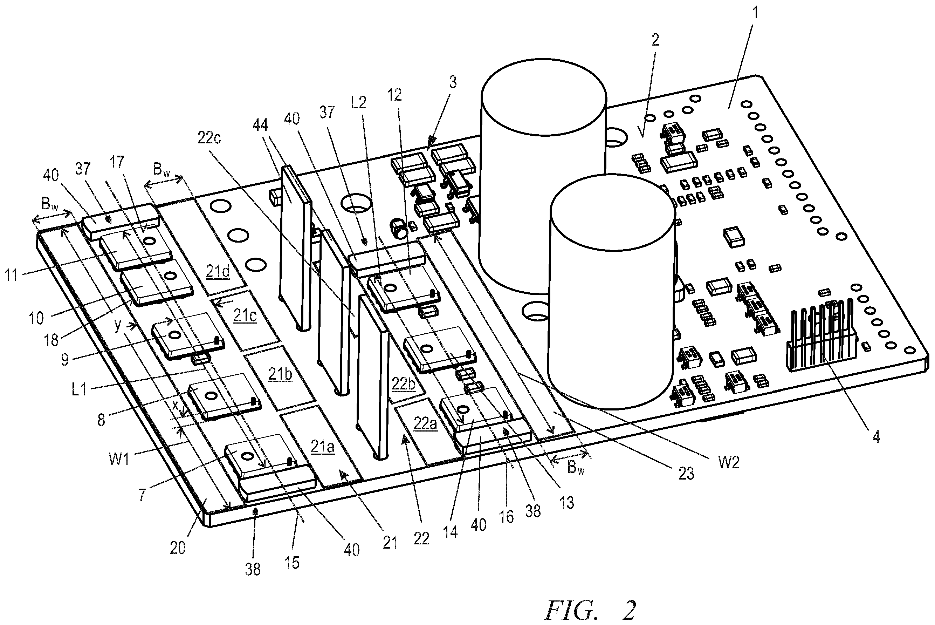

Auf der Platine 1 sind Kühlkörper 5, 6 gehalten, die zur Wärmeabfuhr der Abwärme der elektronischen Bauelemente, insbesondere der elektronischen Leistungsbauteile 7 bis 14 vorgesehen sind. In Fig. 2 sind die Leistungsbauteile 7 bis 11 in einer Reihe 15 angeordnet. Die Leistungsbauteile 12, 13 und 14 sind in einer Reihe 16 angeordnet. Im gezeigten Ausführungsbeispiel liegen die Reihen 15 und 16 zueinander parallel. Eine andere Anordnung kann zweckmäßig sein.

Die Vorrichtung zur Abfuhr von Wärme der auf der Platine 1 montierten elektronischen Bauelemente 3 mit einem Kühlkörper weist auf gegenüberliegenden Seiten zum Beispiel eines Leistungsbauteils 7 oder in der Platine ausgebildete Wärmeleitabschnitte 20, 21, 22 und 23 auf. Jedes elektronische Bauelement, insbesondere die Leistungsbauteile 7 bis 14 weisen jeweils auf einander gegenüberliegenden Seiten die insbesondere einteilig mit der Platine 1 ausgebildeten Wärmeleitabschnitte 20 bis 23 auf.

Es kann zweckmäßig sein, mehreren Leistungsbauteilen 7, 8, 9, 10, 11 einen gemeinsamen Wärmeleitabschnitt 20 zuzuordnen, der sich längs der Reihe 15 der Leistungsbauteile 7 bis 11 erstreckt. Bevorzugt erstreckt sich ein Wärmeleitabschnitt über die gesamte Länge L1, L2 einer Reihe 10, 16 von Leistungsbauteilen. Insbesondere liegt der Wärmeleitabschnitt 20 und/oder 21 parallel zur Reihe 15 der Leistungsbauteile 7 bis 11. Vorteilhaft liegt der Wärmeleitabschnitt 22 und/oder 23 parallel zur Reihe 16 der Leistungsbauteile 12 bis 14.

Es kann vorteilhaft sein, den einem elektronischen Bauelement bzw. einem elektronischen Leistungsbauteil zugeordneten Wärmeleitabschnitt getrennt von dem Wärmeleitabschnitt eines benachbarten Bauelementes bzw. Leistungsbauteils auszubilden. So besteht der in Figur 2 gezeigte Wärmeleitabschnitt 21 aus vier Teilabschnitten 21a, 21b, 21c und 21d. Die Teilabschnitte 21a, 21b und 21c sind jeweils einem einzigen Leistungsbauteil 7, 8 bzw. 9 zugeordnet, während der Teilabschnitt 21d zwei benachbarten Leistungsbauteilen 10 und 11 zugeordnet ist. Der aus den Teilabschnitten 21a, 21b, 21c und 21d zusammengesetzte Wärmeleitabschnitt 21 hat eine Länge W1, die größer ist als die Länge L1 der Reihe der Leistungsbauteile 7 bis 11.

Entsprechend weist die Reihe 16 von elektronischen Bauelementen bzw. elektronischen Leistungsbauteilen 12, 13 und 14 auf einer Seite der Reihe 16 einen insbesondere durchgehenden gemeinsamen Wärmeleitabschnitt 23 auf. Auf der anderen Seite der Reihe 16 der Leistungsbauteile 12 bis 14 ist jedem Leistungsbauteil 12, 13 und 14 ein eigener Teilabschnitt 22a, 22b und 22c des Wärmeleitabschnitts 22 zugeordnet. Der aus den Wärmeleitabschnitten 22a, 22b und 22c zusammengesetzte Wärmeleitabschnitt 22 hat eine Länge W2, die größer als die Länge L2 der Reihe 16 ist.

Die Länge W1 der Wärmeleitabschnitte 20 und 21 ist etwa 10% bis 30% länger als die Länge L1 der durch die Leistungsbauteile 7 bis 11 gebildeten Reihe 15. Die Länge W2 der Wärmeleitabschnitte 22 und 23 ist etwa 10% bis 30% länger als die Länge L2 der durch die Leistungsbauteile 12 bis 14 gebildeten Reihe 16.

Jedes Leistungsbauteil 7 bis 14 weist eine Oberseite 17 und eine Unterseite 18 auf. Die Unterseite 18 des elektronischen Bauelementes bzw. des elektronischen Leistungsbauteils 7 bis 14 liegt auf der Platine 1 auf. Die Unterseite 18 des elektronischen Bauelementes bzw. des elektronischen Leistungsbauteils 7 bis 14 steht dabei in Wärme übertragender Verbindung mit der Platine 1 bzw. den Wärmeleitabschnitten 20, 21, 22 und 23 der Platine 1. Die Wärmeleitabschnitte 20, 21, 22 und 23 bestehen aus gut Wärme leitendem Material. Dieses Wärme leitende Material kann auf der Platine 1 aufgebracht, auf dieser befestigt und/oder in der Platine eingebettet sein.

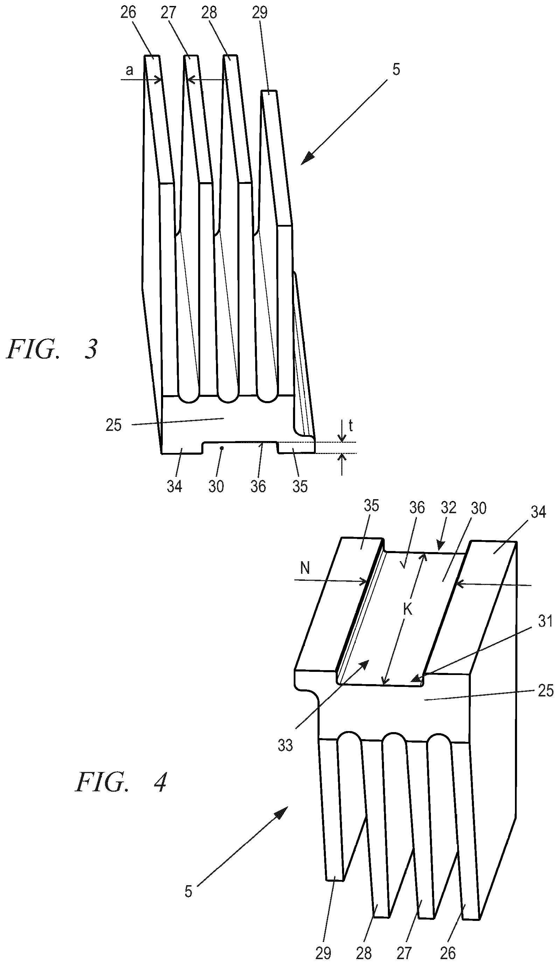

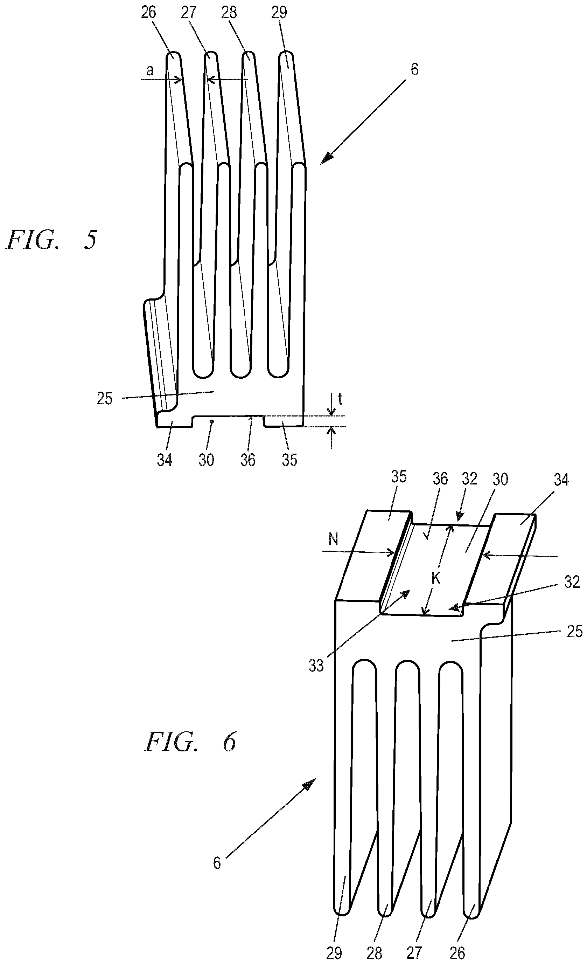

In den Figuren 3 und 4 ist schematisch ein erster Kühlkörper 5 und in den Figuren 5 und 6 ein zweiter Kühlkörper 6 schematisch dargestellt. Jeder Kühlkörper besteht aus einem Grundkörper 25 mit daran angeordneten Kühlrippen 26, 27, 28 und 29. Die Kühlrippen 26, 27, 28 und 29 verlaufen in Längsrichtung des Grundkörpers 25 und liegen mit einem Abstand a zueinander. Die Kühlrippen 26, 27, 28 und 29 können gleich hoch ausgebildet sein; im gezeigten Ausführungsbeispiel hat die Kühlrippe 29 des Kühlkörpers 5 zumindest über eine Teillänge eine geringere Höhe als die übrigen Kühlrippen 26, 27 und 28. Der in den Figuren 5 und 6 dargestellte Kühlkörper 6 weist Kühlrippen gleicher Höhe auf.

Die Kühlkörper 5 und 6 haben einen gleichen Grundaufbau bestehend aus dem Grundkörper 25 und darauf angeordneten Kühlrippen 26 bis 29, wobei im Grundkörper 25 eine Ausnehmung 30 ausgebildet ist. Wie die Figuren 4 und 6 zeigen, erstreckt sich die Ausnehmung 30 vorteilhaft über die gesamte Länge K des Kühlkörpers 5. Die Ausnehmung 30 ist an ihren Enden 31 und 32 offen. Die Ausnehmung 30 bildet eine im Grundkörper 25 eingebrachte Aufnahmenut 33.

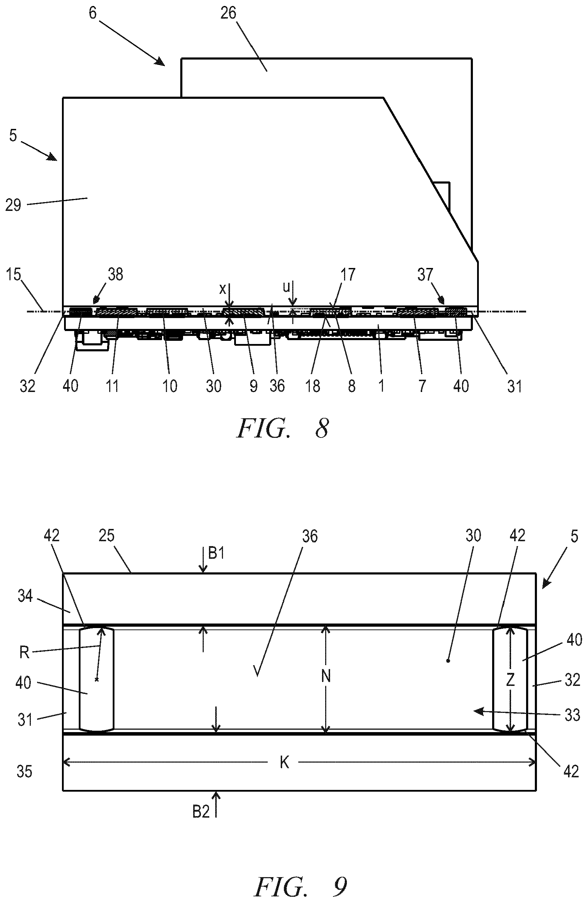

Der Grundkörper 25 des Kühlkörpers 5 bzw. 6 weist zwei Fußabschnitte 34 und 35 auf, die insbesondere als Fußstege ausgebildet sind und die Ausnehmung 30 bzw. die Aufnahmenut 33 begrenzen (Fig. 4, 6 und 9). Die Fußabschnitte 34, 35 erstrecken sich vorzugsweise über die gesamte Länge K des Kühlkörpers 5 und haben eine Breite B1 bzw. B2 (Fig. 9), die der Breite B_{w} eines Wärmeleitabschnittes 20, 21, 22 und 23 angepasst ausgebildet ist. Für einen guten Wärmeübergang von einem Wärmeleitabschnitt 20, 21, 22 oder 23 auf den Kühlkörper 5 bzw. 6 ist es vorteilhaft, wenn die Breite B1 bzw. B2 des auf dem Wärmeleitabschnitt 20, 21, 22 und 23 aufstehenden Fußabschnittes 34 und 35 des Kühlkörpers zumindest der Breite B_{w} eines Wärmeleitabschnittes 20, 21, 22 und 23 entspricht. Bevorzugt beträgt die Breite B1 bzw. B2 des Fußabschnittes 34 bzw. 35 des Kühlkörpers 5 bzw. 6 insbesondere 80% bis 120% der Breite B_{w} des Wärmeleitabschnittes 20, 21, 22 oder 23. Vorteilhaft entspricht die Breite B1 bzw. B2 insbesondere 90% bis 110% der Breite B_{w} des Wärmeleitabschnittes. In einer vorteilhaften Ausführungsform ist die Breite B1 bzw. B2 mit 95% bis 105% der Breite B_{w} des Wärmeleitabschnittes gewählt.

Wie in den Figuren 1, 7 und 8 gezeigt, werden die Kühlkörper 5 und 6 derart auf die Reihen 15 und 16 der Leistungsbauteile 7 bis 11 bzw. 12 bis 14 aufgesetzt, dass ihre Fußabschnitte 34 und 35 unmittelbar auf jeweils einem Wärmeleitabschnitt 20 und 21 bzw. 22 und 23 der Platine 1 aufstehen. Die Anordnung ist so getroffen, dass die elektronischen Leistungsbauteile 7 bis 11 der Reihe 15 bzw. die Leistungsbauteile 12 bis 14 der Reihe 16 in der jeweiligen Ausnehmung 30 des aufgesetzten Kühlkörpers 5 bzw. 6 aufgenommen sind. Vorteilhaft liegen alle Leistungsbauteile 7 bis 11 der Reihe 15 in einer gemeinsamen Ausnehmung 30 und/oder alle Leistungsbauteile 12 bis 14 der Reihe 16 in einer gemeinsamen Ausnehmung 30 des zugeordneten Kühlkörpers 5, 6. Die elektronischen Leistungsbauteile 7 bis 11 der Reihe 15 bzw. die Leistungsbauteile 12 bis 14 der Reihe 16 können in der Ausnehmung 30 vorzugsweise in Wärme übertragender Verbindung mit dem Kühlkörper 5 bzw. 6 stehen.

Es kann zweckmäßig sein, anstelle einer gemeinsamen Ausnehmung 30 im Kühlkörper 5, 6 für jedes Bauelement oder Leistungsbauteil eine getrennte Aufnahme auszubilden, so dass der Grundkörper eines Kühlkörpers 5, 6 mehrere einzelne, voneinander getrennte Aufnahmen aufweist. Die einzelnen Aufnahmen zu einer gemeinsamen Ausnehmung 30 auszubilden, ist eine vorteilhafte Ausführungsform der Erfindung.

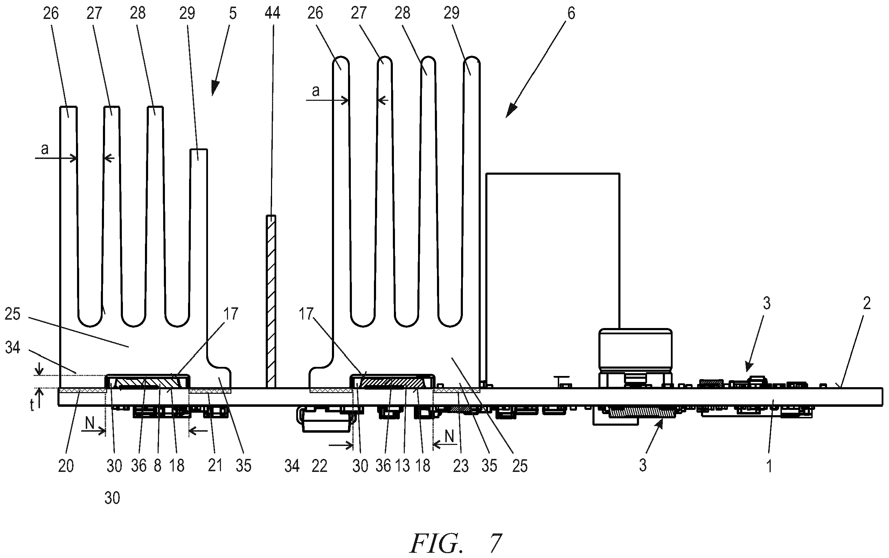

Wie die Figuren 1 und 7 zeigen, stehen die Fußabschnitte 34 und 35 eines Kühlkörpers 5 bzw. 6 auf gegenüberliegenden Seiten eines elektronischen Bauelementes bzw. eines Leistungsbauteils auf jeweils einem Wärmeleitabschnitt. Der Kühlkörper 5 bzw. 6 bildet somit eine Brücke, die das elektronische Bauelement bzw. das Leistungsbauteil 7 bis 14 übergreift. Die Anordnung ist dabei insbesondere so getroffen, dass die Fußabschnitte 34 und 35 eines Kühlkörpers 5 bzw. 6 unmittelbar auf den Wärmeleitabschnitten 20 und 21 bzw. 22 und 23 aufstehen. Es kann zweckmäßig sein, zwischen einem Fußabschnitt 34 und 35 eines Kühlkörpers 5 bzw. 6 und einem Wärmeleitabschnitt 20 und 21 bzw. 22 und 23 der Platine 1 ein wärmeleitendes Material anzuordnen. Ein derartiges wärmeleitendes Material kann in Form eines Pads, einer Wärmeleitpaste, eines Wärmeleitklebers oder dergleichen Material vorgesehen sein.

Der Kühlkörper 5 bzw. 6 steht mit seinen Fußabschnitten 34 und 35 mit den Wärmeleitabschnitten 20 und 21 bzw. 22 und 23 der Platine 1 in Wärme übertragender Verbindung. Vorteilhaft steht der Kühlkörper 5 bzw. 6 zugleich innerhalb der Ausnehmung 30 insbesondere zur Ableitung von Topwärme mit dem elektronischen Bauelement bzw. dem elektronischen Leistungsbauteil in Wärme übertragender Verbindung. Zweckmäßig liegt die Oberseite 17 eines Leistungsbauteils 7 bis 14 am Boden 36 der Ausnehmung 30 Wärme übertragend an. Vorteilhaft ist in einer Lücke u (Fig. 8) zwischen der Oberseite 17 des Leistungsbauteils und dem Boden 36 der Ausnehmung 30 ein wärmeleitendes Material vorgesehen. Das wärmeleitende Material kann in Form eines Pads, einer Wärmeleitpaste, eines Wärmeleitklebers oder dergleichen Material vorgesehen sein. Ferner kann ein Gas (z. B. Luft) oder ein Vakuums vorgesehen sein, wobei der Wärmeübergang vom Bauelement auf den Kühlkörper über Konvektion oder Strahlung erfolgt.

Die Kühlkörper 5 und 6 bestehen aus einem gut wärmeleitenden Material. Ein gut wärmeleitendes Material ist oft elektrisch leitend. Daher muss sichergestellt werden, dass die Kühlkörper 5 und 6 bei der Montage auf die Leistungsbauteile 7 bis 14 keinen elektrischen Kontakt mit den Anschlussfähnchen der Leistungsbauteile haben. Nach der Erfindung ist vorgesehen, dass in die Ausnehmung 30 zumindest ein auf der Platine 1 festgelegtes Zentrierelement 40 eingreift. Das Zentrierelement 40 ist bestimmt und geeignet, den angeordneten Kühlkörper 5 bzw. 6 relativ zum elektronischen Bauelement bzw. dem Leistungsbauteil 7 bis 14 auszurichten. In Reihe mit zumindest einem elektronischen Bauelement bzw. Leistungsbauteil ist zumindest ein Zentrierelement 40 vorgesehen.

Wie die Figuren 2 und 8 zeigen, ist im Anfangsabschnitt 37 und im Endabschnitt 38 einer Reihe 15 bzw. 16 der elektronischen Leistungsbauteile 7 bis 14 zumindest ein Zentrierelement 40 vorgesehen. In vorteilhafter Ausbildung bildet ein Zentrierelement 40 den Anfang und das Ende einer Reihe 15 bzw. 16 der Leistungsbauteile 7 bis 11 bzw. 12 bis 14.

Das Zentrierelement 40 ist im gezeigten Ausführungsbeispiel im Wesentlichen rechteckförmig gestaltet, wie insbesondere die Figuren 9 bis 12 zeigen. Ein Zentrierelement 40 weist dabei eine Länge Z auf, die der quer zur Länge K (Fig. 9) des Kühlkörpers 5 bzw. 6 gemessenen Breite N der Ausnehmung 30 entspricht. Vorteilhaft ist die Länge Z des Zentrierelementes 40 kürzer als die Breite N der Ausnehmung 30. Vorteilhaft entspricht die Länge Z 90% bis 100% der Breite N der Ausnehmung. Insbesondere entspricht die Länge Z 95% bis 98% der Breite N der Ausnehmung 30.

Die Länge Z eines Zentrierelementes 40 entspricht derart der Breite N der Ausnehmung 30, dass ein in die Ausnehmung 30 eingreifendes Zentrierelement 40 geeignet ist, den Kühlkörper 5 bzw. 6 quer zur Längsrichtung eines elektronischen Bauelementes bzw. eines Leistungsbauteils 7 bis 14 oder einer Reihe 15 bzw. 16 der elektronischen Bauelemente bzw. der Leistungsbauteile 7 bis 14 auszurichten. Auf diese Weise wird ein elektrischer Kontakt des einen Leistungsbauteils 7 bis 14 übergreifenden Kühlkörpers 5 bzw. 6 mit den Anschlussfähnchen der Leistungsbauteile 7 bis 14 sicher vermieden.

In besonderer Ausgestaltung der Erfindung ist vorgesehen, dass die Länge Z der Zentrierelemente 40 dem Abstand y (Fig. 2) der einer Reihe 15 bzw. 16 zugeordneten Wärmeleitabschnitte 20, 21 bzw. 22, 23 entspricht. Bevorzugt entspricht die Länge Z des Zentrierelementes 40 insbesondere 95% bis 100% dem Abstand y der einem Leistungsbauteil 7 bis 14 zugeordneten Wärmeleitabschnitte 20, 21 bzw. 22, 23.

Ein durch den Kühlkörper 5 bzw. 6 zu kühlendes Leistungsbauteil 7 bis 14 hat eine Bauhöhe x (Fig. 8). Alle Leistungsbauteile 7 bis 11 der Reihe 15 und alle Leistungsbauteile 12 bis 14 der Reihe 16 haben bevorzugt eine gleiche Bauhöhe x. Die Tiefe t der Ausnehmung 30 entspricht vorteilhaft der Bauhöhe x eines Leistungsbauteils; insbesondere ist die Tiefe t um 0,5% bis 2% tiefer als die Bauhöhe x eines Leistungsbauteils 7 bis 14. Die Tiefe t ist so bemessen, dass alle Leistungsbauteile einer Reihe 15 bzw. 16 mit ihrer Oberseite 17 - gegebenenfalls unter Einfügen eines wärmeleitfähigen Materials wie eines Pads, einer Wärmeleitpaste oder eines Wärmeleitklebers - mit dem Boden 36 der Ausnehmung 30 einen Wärme leitenden Kontakt haben.

Zur Ausrichtung eines Kühlkörpers 5, 6 auf der Platine 1 ist das Zentrierelement 40 auf der Platine 1 mechanisch festgelegt. Das Zentrierelement 40 weist eine Höhe c auf, die vorteilhaft der Tiefe t der Ausnehmung 30 im Kühlkörper 5 bzw. 6 entspricht oder zweckmäßig geringer als die Tiefe t ist. Wird in einer Weiterbildung der Erfindung die Tiefe t der Ausnehmung 30 im Kühlkörper 5 bzw. 6 insbesondere an die Bauhöhe x des elektronischen Bauelementes 3 bzw. des Leistungsbauteils 7 bis 14 angepasst, kann vorteilhaft erreicht werden, dass die Oberseite 17 eines Leistungsbauteils 7 bis 14 einen gut Wärme leitenden Kontakt mit dem Kühlkörper 5 bzw. 6 hat. Die Höhe c des Zentrierelementes 40 ist geringer oder gleich der Bauhöhe x des Leistungsbauteils 7 bis 14. Bevorzugt ist die Höhe c des Zentrierelementes 40 kleiner als die Bauhöhe x des Leistungsbauteils, so dass das Zentrierelement 40 lediglich der Funktion zur Ausrichtung des Kühlkörpers quer zur Reihe 15 bzw. 16 der Leistungsbauteile 7 bis 14 dient.

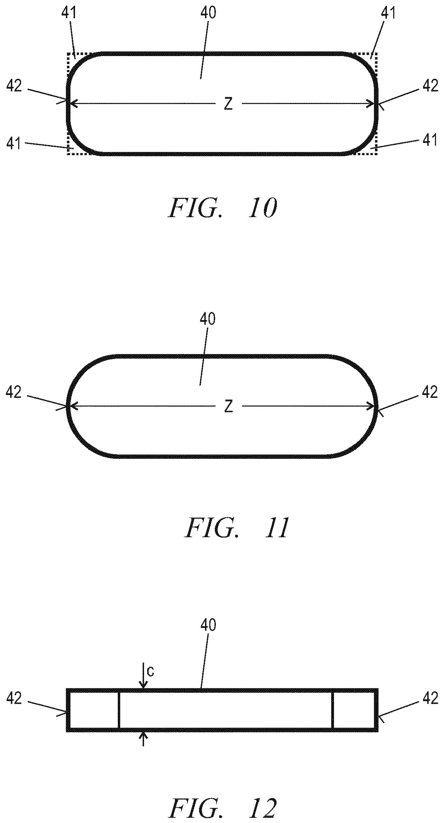

Das Zentrierelement 40 kann die in Fig. 10 strichliert dargestellte Rechteckform aufweisen. Sind die Zentrierplättchen 40 auf der Platine 1 positionsgenau montiert, ist ein Aufsetzen des Kühlkörpers 5 bzw. 6 auf das Zentrierelement 40 möglich. Werden die Ecken 41 des Zentrierelementes 40 gerundet, so wie dies in Fig. 10 dargestellt ist, können Positionsabweichungen der Lageanordnung des Zentrierelementes 40 auf der Platine 1 ausgeglichen werden. Aufgrund der gerundeten Ecken des Zentrierelementes 40 nach Fig. 10 ist auch bei unterschiedlichen Winkellagen der Zentrierelemente 40 in einer Reihe 15 bzw. 16 eine einfache Montage des Kühlkörpers 5 bzw. 6 gewährleistet. In Fig. 9 ist dargestellt, wie mit angeordneten Zentrierelementen 40 einer Reihe eine ausreichende Lageausrichtung des Kühlkörpers 5 bzw. 6 durch die Zentrierelemente 40 einer Reihe 15 bzw. 16 erzielt wird.

In einer weiteren Ausbildung eines Zentrierelementes 40 nach Fig. 11 ist vorgesehen, die Stirnseiten 42 des Zentrierelementes 40 gerundet auszuführen. Bevorzugt sind die Stirnseiten 42 als Halbkreisbögen ausgebildet. In besonderer Ausgestaltung eines Zentrierelementes 40 kann eine Stirnseite mit einem Radius R gerundet sein, der insbesondere der halben Länge Z eines Zentrierelementes 40 entspricht. Es kann vorteilhaft sein, den Radius R der Rundung einer Stirnseite auch größer auszubilden, z. B. in einem Bereich von einer halben Länge Z bis zu einem Mehrfachen von Z, z. B. der fünffachen Länge Z.

## Patentansprüche

1. Vorrichtung zur Abfuhr von Wärme eines auf einer Platine (1) montierten elektronischen Bauelementes (3) mit einem Kühlkörper, insbesondere zur Abfuhr von Wärme eines elektronischen Leistungsbauteils (7 bis 14), wobei auf der Platine (1) zumindest ein Wärme abführender Wärmeleitabschnitt (20, 21, 22, 23) ausgebildet ist, und der Kühlkörper (5, 6) in Wärme übertragender Verbindung mit dem zumindest einen Wärmeleitabschnitt (20, 21, 22, 23) der Platine (1) steht,
**dadurch gekennzeichnet, dass** der Kühlkörper (5, 6) mit einem Fußabschnitt (34, 35) unmittelbar auf dem Wärmeleitabschnitt (20, 21, 22, 23) der Platine (1) aufsteht, dass im Grundkörper (25) des Kühlkörpers (5, 6) eine Ausnehmung (30) ausgebildet ist, und dass das elektronische Bauelement (3) zumindest teilweise in der Ausnehmung (30) liegt.

2. Vorrichtung nach Anspruch 1,
**dadurch gekennzeichnet, dass** der Kühlkörper (5, 6) auf einander gegenüberliegenden Seiten der Ausnehmung (30) mit je einem Fußabschnitt (34, 35) ausgebildet ist.

3. Vorrichtung nach Anspruch 2,
**dadurch gekennzeichnet, dass** die Platine (1) auf gegenüberliegenden Seiten des elektronischen Bauelementes (3) zumindest einen Wärmeleitabschnitt (20, 21, 22, 23) aufweist, wobei der Kühlkörper (5, 6) das elektronische Bauelement (3) als Brücke übergreift und mit je einem Fußabschnitt (34, 35) unmittelbar auf einem Wärmeleitabschnitt (20, 21; 22, 23) aufsteht.

4. Vorrichtung nach einem der Ansprüche 1 bis 3,
**dadurch gekennzeichnet, dass** mehrere elektronische Bauelemente (3) längs zumindest eines Wärmeleitabschnittes (20, 21, 22, 23) der Platine (1) in einer Reihe (15, 16) nebeneinander angeordnet sind, und den elektronischen Bauelementen (3) und den Wärmeleitabschnitten (20, 21, 22, 23) der Reihe (15, 16) ein gemeinsamer Kühlkörper (5, 6) zugeordnet ist.

5. Vorrichtung nach Anspruch 4,
**dadurch gekennzeichnet, dass** die elektronischen Bauelemente (3) der Reihe (15, 16) in einer gemeinsamen Ausnehmung (30) des Kühlkörpers (5, 6) liegen.

6. Vorrichtung nach einem der Ansprüche 1 bis 5,
**dadurch gekennzeichnet, dass** sich der Fußabschnitt (34, 35) des Kühlkörpers (5, 6) über die Länge eines elektronischen Bauelementes (3) oder über die Länge (L1, L2) der Reihe (15, 16) der elektronischen Bauelemente (3) erstreckt.

7. Vorrichtung nach einem der Ansprüche 1 bis 6,
**dadurch gekennzeichnet, dass** in die Ausnehmung (30) des Kühlkörpers (5, 6) zumindest ein auf der Platine (1) festgelegtes Zentrierelement (40) eingreift, das geeignet und bestimmt ist, den Kühlkörper (5, 6) relativ zum elektronischen Bauelement (3) auszurichten.

8. Vorrichtung nach Anspruch 7,
**dadurch gekennzeichnet, dass** in Reihe mit zumindest einem elektronischen Bauelement (3) das zumindest eine Zentrierelement (40) liegt.

9. Vorrichtung nach Anspruch 7 oder 8,
**dadurch gekennzeichnet, dass** quer zum Wärmeleitabschnitt (20, 21, 22, 23) die Länge (Z) eines Zentrierelementes (40) der Breite (B_{w}) der Ausnehmung (30) im Kühlkörper (5, 6) derart entspricht, dass ein in die Ausnehmung (30) eingreifendes Zentrierelement (40) geeignet ist, den Kühlkörper (5, 6) quer zur Längsrichtung des Wärmeleitabschnittes (20, 21, 22, 23) und des elektronischen Bauelementes (3) auszurichten.

10. Vorrichtung nach einem der Ansprüche 7 bis 9,
**dadurch gekennzeichnet, dass** das Zentrierelement (40) eine Höhe (c) aufweist, die geringer als oder gleich ist wie die Tiefe (t) der Ausnehmung (30) im Kühlkörper.

11. Vorrichtung nach einem der Ansprüche 7 bis 10,
**dadurch gekennzeichnet, dass** das Zentrierelement (40) mit gerundeten Ecken (41), insbesondere mit gerundeten Stirnseiten (42) ausgebildet ist.

12. Vorrichtung nach einem der Ansprüche 7 bis 11,
**dadurch gekennzeichnet, dass** im Anfangsabschnitt (37) und im Endabschnitt (38) einer Reihe (15, 16) von elektronischen Bauelemente (3) zumindest ein Zentrierelement (40) angeordnet ist.

13. Vorrichtung nach Anspruch 12,
**dadurch gekennzeichnet, dass** ein Zentrierelement (40) einen Anfang und ein Zentrierelement (40) ein Ende der Reihe (15, 16) der elektronischen Bauelemente (3) bildet.

14. Vorrichtung nach einem der Ansprüche 1 bis 13,
**dadurch gekennzeichnet, dass** das elektronische Bauelement (3) in der Ausnehmung (30) in Wärme übertragender Verbindung mit dem Kühlkörper (5, 6) steht.

15. Vorrichtung nach einem der Ansprüche 1 bis 14,
**dadurch gekennzeichnet, dass** das elektronische Bauelement (3) eine der Platine (1) zugewandte Unterseite (18) und eine von der Platine (1) abgewandte Oberseite (17) aufweist, wobei die Unterseite (18) des elektronischen Bauelementes (3) zur Abfuhr von Bottomwärme mit einem Wärmeleitabschnitt (20, 21, 22, 23) der Platine (1) in Wärme übertragender Verbindung steht, und die Oberseite (17) des elektronischen Bauelementes (3) zur Abfuhr von Topwärme mit dem Boden (36) der Ausnehmung (30) der Kühlkörpers (5, 6) in Wärme übertragender Verbindung steht.
